# EUROPEAN PATENT APPLICATION

(11) **EP 4 411 802 A1**
(43) Date of publication of application: **07.08.2024**
(21) Application number: 23154814.0
(22) Date of filing: 03.02.2023
(51) Int. Cl.: H01L 23/00

(54) **PACKAGE WITH COMPONENT CARRIER AND ELECTRONIC COMPONENT CONNECTED BY MICRO- AND/OR NANOSTRUCTURES**

(71) Applicant: AT & S Austria Technologie & Systemtechnik Aktiengesellschaft, 8700 Leoben-Hinterberg (AT)
(72) Inventor: GAVAGNIN, Marco, 8700 Leoben (AT); LEITGEB, Markus, 8793 Trofaiach (AT)
(74) Representative: Dilg, Haeusler, Schindelmann Patentanwaltsgesellschaft mbH

(57) **Abstract**

A package (100) which comprises a component carrier (102) having a stack (104) comprising at least one electrically conductive layer structure (106) and at least one electrically insulating layer structure (108), wherein the at least one electrically conductive layer structure (106) comprises at least one carrier pad (120), an electronic component (110) assembled with the component carrier (102) and comprising at least one component pad (122), and a connection structure (112) configured for electromechanically connecting the at least one carrier pad (120) with the at least one component pad (122) by micro- and/or nanostructures (114), wherein the micro- and/or nanostructures (114) are made of the same material as the at least one carrier pad (120) and/or the at least one component pad (122).

## Description

### Field of the Invention

The invention relates to a package, and to a method of manufacturing a package.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

US 2011/0039459 discloses that solderless and durable electrical contacts may be made by growing carbon nanotube (CNT) or nanowire forests in a solderless manner directly on the contact surfaces of integrated circuits, PCBs, IC packages, hybrid substrates, contact carriers, rotor components, stator components, etc. The electrical contacts and methods may be employed in a variety of leaded and leadless electronic packaging applications on PCBs, IC packages, and hybrid substrates including ball grid array (BGA) packages, land grid array (LGA) and leadless chip carrier (LCC) packages, as well as for making interconnections in flip-chip configurations, bare die configurations, and interconnection of integrated circuit die in multi-layer and 3-D stacking arrangements.

Conventional approaches of forming and handling component carriers are still challenging in particular what concerns mounting of electronic components thereon and/or therein.

### Summary of the Invention

There may be a need to form a compact and reliable component carriertype package.

According to an exemplary embodiment of the invention, a package is provided which comprises a component carrier having a stack comprising at least one electrically conductive layer structure and at least one electrically insulating layer structure, wherein the at least one electrically conductive layer structure comprises at least one carrier pad, an electronic component assembled with the component carrier and comprising at least one component pad, and a connection structure configured for electromechanically connecting the at least one carrier pad with the at least one component pad by micro- and/or nanostructures, wherein the micro- and/or nanostructures are made of the same material as the at least one carrier pad and/or the at least one component pad.

According to another exemplary embodiment of the invention, a method of manufacturing a package is provided, wherein the method comprises providing a component carrier having a stack comprising at least one electrically conductive layer structure and at least one electrically insulating layer structure, wherein the at least one electrically conductive layer structure comprises at least one carrier pad, assembling an electronic component, which comprises at least one component pad, with the component carrier, and electromechanically connecting the at least one carrier pad with the at least one component pad by a connection structure comprising micro- and/or nanostructures, wherein the micro- and/or nanostructures are made of the same material as the at least one carrier pad and/or the at least one component pad.

In the context of the present application, the term "package" may particularly denote a device having at least one electronic component (such as a semiconductor chip) being surface mounted on and/or embedded in a component carrier (like an integrated circuit (IC) substrate or a printed circuit court (PCB)) being mechanically and electrically connected with each other. Such a package may be a constituent of more complex electronic devices.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an IC (integrated circuit) substrate. A component carrier may also be a hybrid board combining different ones of the above mentioned types of component carriers.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the stacked layer structures may be arranged parallel to each other.

In the context of the present application, the term "layer structure" may particularly denote a continuous layer, a patterned layer or a plurality of nonconsecutive islands within a common plane.

In the context of the present application, the term "carrier pad" may particularly denote a (for example flat and/or planar) electrically conductive contact element of the component carrier. Such a carrier pad may be accessible at a main surface of the component carrier for electric connection purposes or may be an embedded carrier pad. The main horizontal extension (i.e. perpendicular to the thickness direction of the component carrier) of the exposed carrier pad may be parallel to the plane of the layers of the component carrier stack.

In the context of the present application, the term "electronic component" may particularly denote a device or member fulfilling an electronic task. Such an electronic component may be a passive component such as a capacitor component. It is also possible that an electronic component may be an active component such as a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a bare die or a molded die. At least one integrated circuit element may be monolithically integrated in such a semiconductor chip.

In the context of the present application, the term "component pad" may particularly denote a (for example flat and/or planar) electrically conductive contact element of the electronic component being accessible at a main surface of the electronic component for electric connection purposes. The main horizontal extension (i.e. perpendicular to the thickness direction of the component) of the exposed component pad may be parallel to the plane of the layers of the component carrier stack.

In the context of the present application, the term "connection structure for electromechanically connecting pads" may particularly denote a physical structure providing an electric connection between the pads and providing a mechanical connection as well between the pads. The electric connection may electrically couple the pads for enabling a transfer of electric signals and/or electric power. The mechanical connection may mechanically couple the pads for ensuring mechanical integrity of the package for withstanding mechanical load occurring during normal operation. A connection between component pad and carrier pad may be ensured by a connection structure which may be configured for electromechanically connecting said pads.

In the context of the present application, the term "micro- and/or nanostructures" may particularly denote structures having dimensions in the order of magnitude of micrometers (in case of microstructures) or having dimensions in the order of magnitude of nanometers (in case of nanostructures). For example, said micro- and/or nanostructures may comprise micro- and/or nanowires, micro- and/or nanotubes and/or micro- and/or nanopores in a micro- and/or nano-porous body. In particular, micro- and/or nanostructures embodied as micro- and/or nanowires and/or micro- and/or nanotubes may be lengthy filaments having a diameter in the order of magnitude of micrometers or nanometers, respectively. Correspondingly, nanopores in a micro- and/or nano-porous body may be elongate channels in a sponge-like body. For example, the micro- and/or nanostructures may be manufactured by plating or by a deposition process, optionally on a catalytic base.

In the context of the present application, the term "micro- and/or nanostructures and pad(s) made of the same material" may particularly denote that the micro- and/or nanostructures and the at least one pad consist of identical material, in particular the surface material of the component pad and/or connection pad. However, the micro- and/or nanostructures and the at least one pad made of the same material may also only share the same main material (which may form at least 95 weight percent, in particular at least 99 weight percent, of the micro- and/or nanostructures and of the at least one pad), while one or more additives (which may form together not more than 5 weight percent, in particular not more than 1 weight percent, of the micro- and/or nanostructures and the at least one pad) may be different between the micro- and/or nanostructures and the at least one pad. For instance, impurities, manufacturing tolerances, different manufacturing processes and similar technically unavoidable phenomena may cause such a slight deviation.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an embodiment of the invention, a package may comprise a layer stack-type component carrier (such as a printed circuit board or an integrated circuit substrate) with one or more carrier pads, which may be exposed to simplify a connection thereof. An electronic component (for example a semiconductor chip) may be assembled with (for example may be surface mounted on or embedded in) the component carrier and may be provided with one or more component pads, which may be exposed to simplify a connection thereof. Advantageously, a connection structure may be provided for electromechanically connecting the carrier pad(s) with the component pad(s) by the use of micro- and/or nanostructures. Such an array of micro- and/or nanostructures may advantageously provide the package with elasticity and flexibility for balancing mechanical impacts exerted to the package during manufacture and/or during operation. For example, the micro- and/or nanostructures may counterbalance or buffer mechanical stress exerted between component carrier and assembled electronic component. Furthermore, the micro- and/or nanostructures may tolerate a certain angular misalignment between component carrier and component. This may also ensure a good connection even if the component is attached with inclination (for instance with an angle between 1° and 30°). This may encompass a slight equilibration motion in the event of shear forces, tensile stress, twisting, and/or thermal expansion between component carrier and electronic component(s) during a manufacturing process and/or during operation of the package. Advantageously, the micro- and/or nanostructures on the one hand and the one or more carrier and/or component pads on the other hand may be made of the same material. Beneficially, this may prevent material bridges between the micro- and/or nanostructures and the pad(s). Such material bridges may be mechanical weak points being particularly prone to failure. Furthermore, such material bridges may add an undesired contact resistance or transition resistance. The same material of the micro- and/or nanostructures and the pad(s) may also lead to a sufficiently small CTE (coefficient of thermal expansion) mismatch around the connection structure, so that the package may be properly protected against thermal stress. Moreover, even in case of a CTE mismatch between material of the electronic component (for example a semiconductor chip comprising silicon) and a component carrier (in particular a laminate substrate) a high reliability of the package may be ensured even without an additional interposer or the like due to the stress balancing function of the elastic micro- and/or nanostructures. Thus, a reliable package may be manufactured in a compact and simple way.

### Detailed Description of Exemplary Embodiments

In the following, further exemplary embodiments of the package and the method will be explained.

In an embodiment, the micro- and/or nanostructures comprise nanowires, in particular copper nanowires. The term "nanowire" may denote in particular a nanostructure in the form of a wire with a diameter of the order of a nanometer, for instance a diameter of not more than 900 nm, for example of not more than 10 nm. More generally, nanowires can be defined as structures that have a thickness or diameter constrained to tens of nanometers or less and an unconstrained length. For example, nanowires may comprise or consist of one or more electrically conductive (in particular metallic) materials, such as copper, nickel, platinum, gold and/or silver. Also nanowires or nanotubes made of electrically conductive carbon may be possible. An array or a forest of metallic nanowires may have advantageous properties in terms of electrical conductivity and mechanical robustness, and may have an excellent elasticity. Moreover, the array or forest of metallic nanowires may ensure the transport of high currents, for instance at least 1 A/mm², in particular at least 10 A/mm².

In an embodiment, the micro- and/or nanostructures comprise a nano-porous body, in particular nano-porous copper. A nano-porous body may be a solid body having a plurality of an elongate pores. These pores may extend through the body separately from each other and/or being interconnected with each other. A nano-porous body may have excellent properties in terms of electrical conductivity and mechanical robustness, and may have a proper elasticity. The nano-porous body may be preferably made of a metallic material. Most preferred may be a nano-porous body made of copper, because this may lead to full compatibility with a copper-based component carrier, such as a PCB or an IC substrate comprising copper pads and traces.

In an embodiment, the micro- and/or nanostructures comprise or consist of a metal, preferably copper. Micro- and/or nanostructures which are made of a metal combine high electrical conductivity with high thermal conductivity and high mechanical robustness while at the same time allowing for a sufficient degree of elasticity. Moreover, a metal, in particular copper, may provide a high thermal conductivity, which may be used for the transport of heat.

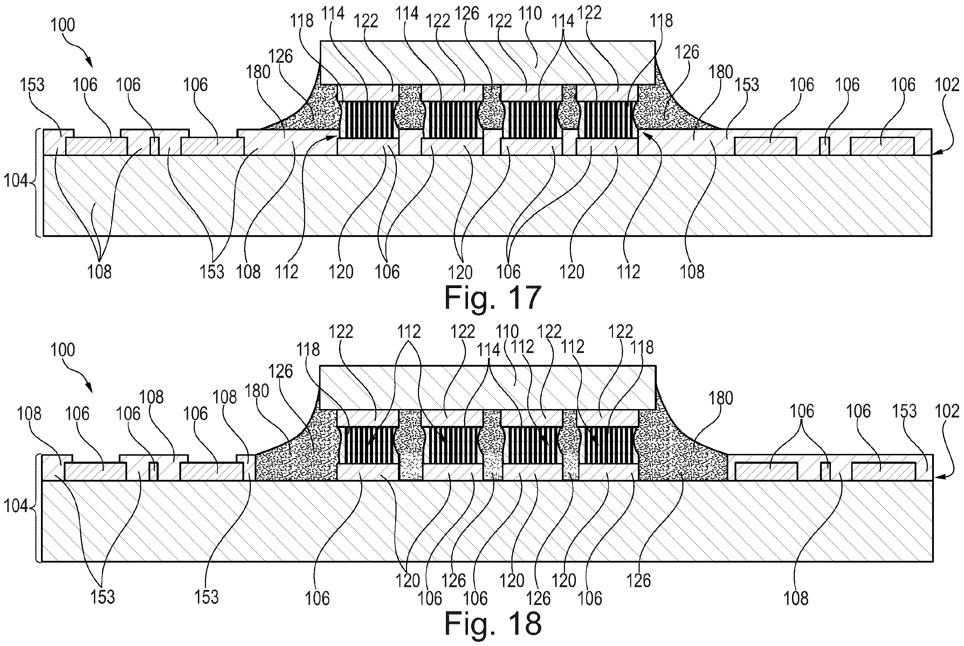

In an embodiment, the stack comprises an external layer structure (for instance an underfill or a solder mask) covering lateral walls, in particular also covering a portion of an upper exposed surface, of the at least one carrier pad (see Figure 17 and Figure 18). This may have the advantage of a protection of the micro- and/or nanostructures from interaction with an external environment (for instance preventing oxidation). Further additionally, the external layer structure may cover at least a portion of micro- and/or nanostructures, respectively. In the context of the present application, the term "external layer structure" may denote an electrically insulating material, such as a resin. Additionally or alternatively, the "external layer structure" may comprise a solder mask material and/or a ceramic material. The external layer structure may cover at least a portion of the carrier pad. Alternatively or additionally, the external layer structure may be constituent of an entire layer of the stack. This may bring the advantage of forming a reliable connection between the electronic component and the component carrier. Furthermore, the at least one carrier pad and/or portions of the micro- and/or nanostructures may be protected from the environment, i.e. from oxygen and/or water.

In an embodiment, the micro- and/or nanostructures have a ratio between a length and a diameter of at least 10, in particular of at least 40. Hence, the micro- and/or nanostructures may be provided with a high aspect ratio. This may promote the elastic properties of the micro- and/or nanostructures, leading to a package with a pronounced capability of balancing out mechanical and thermal load, which may result in a long lifetime of the package.

In an embodiment, the micro- and/or nanostructures form a forest of micro- and/or nanostructures extending from the component carrier and/or from the electronic component. A "forest" may be a two-dimensional array of micro- and/or nanostructures extending or growing from a common base, in particular the respective carrier pad or component pad. The micro- and/or nanostructures of a forest may extend separately from each other or may be cross-linked and/or intertangled. The provision of a forest of micro- and/or nanostructures may provide a plurality of said micro- and/or nanostructures, for instance at least 10 or at least 100 per pad. This may ensure a high mechanical robustness and a high electric conductivity without compromising on elasticity.

In an embodiment, the micro- and/or nanostructures are mutually spaced with respect to each other, in particular at and/or next to a common base (such as the respective carrier pad or component pad) from which the micro- and/or nanostructures extend. For example, the micro- and/or nanostructures may be grown directly on the respective carrier pad or component pad with mutual spacing between adjacent micro- and/or nanostructures. The micro- and/or nanostructures protruding beyond the assigned base pad may extend separate from each other or may be cross-linked and/or intertangled with adjacent micro- and/or nanostructures. Nevertheless, the mutual spacing between the micro- and/or nanostructures may ensure that a sufficiently high degree of elasticity may be maintained for balancing out mechanical and/or thermal stress. Furthermore, empty spaces between the micro- and/or nanostructures can be optionally filled with an appropriate filling medium, for instance for enhancing mechanical robustness of the connection structure or for passivating the micro- and/or nanostructures. Such a filling medium may be an electrically conductive filling medium, such as a solder, for also providing solderability. It is also possible that the filling medium fulfils another function, for instance a protection of the micro- and/or nanostructures against oxidation and/or corrosion. Furthermore, it is also possible that the filling medium provides mechanical robustness.

In an embodiment, the micro- and/or nanostructures provide a permanent non-separable connection between the component carrier and the electronic component. For example, micro- and/or nanostructures extending from each of two opposing pads may be configured for forming a permanent non-separable connection by being pressed together. In particular, when the component carrier with component pad having micro- and/or nanostructures and the electronic component with component pad having further micro- and/or nanostructures are pressed together, the micro- and/or nanostructures entangle or engage the further micro- and/or nanostructures such that the micro- and/or nanostructures will not easily disengage. Such an entangling of sufficiently many and sufficiently dense micro- and/or nanostructures may be so complex and pronounced that a permanent connection between component carrier and electronic component(s) will be created by the connection structure. This combines a simple connection process with a reliably interconnected package. The permanent character of the connection may be further strengthened by optionally filling gaps between the micro- and/or nanostructures by a filling medium such as a solder. By applying elevated temperature while pressing, for instance above 90°C, in particular above 150°C and especially above 170°C, it can also withstand more than 200°C for a certain period of time. Alternatively, the connection may be solderless.

In an embodiment, the micro- and/or nanostructures are configured to act as a spring, in particular to impart elastic properties to the connection structure. Thus, the micro- and/or nanostructures may be formed with a property to avoid a plastic deformation of the connection structure in the event of mechanical and/or thermal stress. Advantageously, the array of micro- and/or nanostructures extending from at least one of the opposing carrier and/or component pads may be configured so that the response of the micro- and/or nanostructures correspond to that of a mechanical spring. In particular, the micro- and/or nanostructures may be configured for experiencing a behaviour according to Hooke's law. According to Hooke's law, a force needed to extend or compress spring-type micro- and/or nanostructures by some distance scales linearly with respect to that distance. Such a characteristic allows the micro- and/or nanostructures to respond properly to external forces for preventing the package from damage. In particular, such a configuration of the micro- and/or nanostructures may also avoid a plastic deformation of the micro- and/or nanostructures in the event of stress which might deteriorate or even damage the electromechanical connection between component carrier and electronic components by the micro- and/or nanostructures of the connection structure.

In an embodiment, the micro- and/or nanostructures acting as spring are configured to generate a restoring force in the event of an elongation within a connection plane between the component carrier and the electronic component. To put it shortly, the spring properties of the micro- and/or nanostructures may generate a back-driving force in a plane corresponding to the facing main surfaces of component carrier and electronic component. In particular, correspondingly configured micro- and/or nanostructures may be capable of buffering shear forces between component carrier and electronic com ponent.

Alternatively, the micro- and/or nanostructures may be configured without intrinsic relaxation characteristic. Then, the micro- and/or nanostructures may be only flexible, but inelastic.

In an embodiment, the micro- and/or nanostructures acting as spring are configured to generate a restoring force in the event of an elongation (which may be an expansion or a compression) along a connection direction between the component carrier and the electronic component. Descriptively speaking, the spring properties of the micro- and/or nanostructures may generate a back-driving force in a direction perpendicular to a plane corresponding to the facing main surfaces of component carrier and electronic component. In particular, correspondingly configured micro- and/or nanostructures may be capable of being elastically deformed in the event of tensile or compressive forces acting between component carrier and electronic component.

Preferably, the configuration of the micro- and/or nanostructures may be so that they may respond both to forces within a connection plane between component carrier and electronic component as well as perpendicular to the connection plane. This may protect the package against stress of very different types.

In an embodiment, the micro- and/or nanostructures are coated by a functional coating. Such a coating may cover a respective micro- and/or nanostructure partially or entirely, and/or may cover only part of an array of micro- and/or nanostructures partially or entirely, whereas others may remain exposed. Such a functional coating may be configured for providing or enhancing at least one dedicated function. For example, the functional coating may be configured for protecting the micro- and/or nanostructures against corrosion and/or oxidation. For instance, the micro- and/or nanostructures may be made of copper which may be prone to oxidation by air or corrosion by humidity in the surrounding. Oxidation or corrosion of such micro- and/or nanostructures may for example deteriorate the electric conductivity and may therefore weaken the electromechanical connection. By an anti-oxidative and/or anticorrosive coating, such an undesired phenomenon can be reliably prevented. Additionally or alternatively, the functional coating may be configured for enhancing thermal conductivity of the micro- and/or nanostructures. This may promote temperature equalization within the package, which may prevent thermal stress. Additionally or alternatively, the functional coating may enhance the electric conductivity of the micro- and/or nanostructures. This may reduce losses of signal quality and/or electric energy which may be transferred between component carrier and electronic components. For enhancing thermal and/or electrical conductivity, the micro- and/or nanostructures may be coated for example by graphene. In yet another embodiment, the functional coating may render the micro- and/or nanostructures solderable (i.e. may enable the micro- and/or nanostructures to be solderable), for example by coating the micro- and/or nanostructures with a solder coating (such as Sn and Sn alloys).

In an embodiment, a first part of the micro- and/or nanostructures extends from the component carrier towards the electronic component, and a second part of the micro- and/or nanostructures extends from the electronic component towards the component carrier, so that the first part and the second part of the micro- and/or nanostructures mesh to form an interconnected connection network. In other words, the first part and the second part of the micro- and/or nanostructures may be inter-tangled one to each other. By entangling micro- and/or nanostructures protruding from both opposing pads to be connected, a very simple connection between component carrier and electronic component may be achieved by merely pressing component carrier and electronic component together while ensuring that the micro- and/or nanostructures extending from the facing pads are in sufficient spatial alignment with each other. This may be sufficient for establishing a reliable electromechanical connection. For instance, one end of a respective micro- and/or nanostructure may be connected to the carrier pad or the component pad while the opposing other end thereof may be a free end. For example, the micro- and/or nanostructures may extend from the carrier or component pad and may end in a gap between the carrier pad and the component pad. Hence, a respective micro- and/or nanostructure may bridge only part of a spacing between the pads to be connected, but an array of micro- and/or nanostructures may bridge the entire spacing.

In an embodiment, the connection structure comprises a solder structure being connected with the micro- and/or nanostructures, in particular with the micro- and/or nanostructures extending only from one of the component carrier and the electronic component. In such embodiments, it may for instance be possible to combine micro- and/or nanostructures with solder for establishing a highly reliable electromechanical connection between component carrier and electronic component. The micro- and/or nanostructures may provide a high connection surface to be wetted or contacted by flowable solder which may promote a very strong electromechanical connection in between. In one alternative, it may be possible to form micro- and/or nanostructures only on one of the pads to be connected, and to connect them with solder bridging said micro- and/or nanostructures with the other pad. It is however also possible to provide micro- and/or nanostructures at both opposing pads, to create a (for instance preliminary) connection by entangling micro- and/or nanostructures extending from both opposing pads with each other and to fix said connection subsequently by soldering.

In an embodiment, the micro- and/or nanostructures are embedded, in particular entirely, in the solder structure. This may lead to a high connection surface and consequently to a highly reliable electromechanical connection between component carrier and electronic component.

In an embodiment, the micro- and/or nanostructures are at least partially outside of the solder structure. The portion of the micro- and/or nanostructures protruding beyond the solder structure may then provide a sufficient degree of elasticity (preferably in accordance with a spring characteristics). The portion of the micro- and/or nanostructures extending into the solder structure may ensure a sufficient robustness and a reliable electric connection in between.

In an embodiment, the package comprises an underfill, in particular an electrically insulating underfill, in a gap between the component carrier and the electronic component. Such a preferably dielectric underfill may close voids between component carrier and electronic component and may therefore improve the mechanical integrity and hence reliability of the package. Additionally, an external layer structure may be laterally placed between the electronic component and the component carrier. Furthermore, an underfill may provide a protection against oxidation and/or corrosion of the micro- and/or nanostructures and/or may electrically insulate the micro- and/or nanostructures. The underfill and/or a solder structure may strengthen the connection of the micro- and/or nanostructures.

In an embodiment, a diameter of a respective one of the micro- and/or nanostructures is in a range from 10 nm to 5 µm. Additionally or alternatively, a length of a respective one of the micro- and/or nanostructures is in a range from 30 nm to 100 µm, preferably in a range from 300 nm to 50 µm. Such micro- and/or nanostructures may provide advantageous properties in terms of reliably electromechanically interconnecting electronic component and component carrier while ensuring a sufficient degree of elasticity of the obtained package for buffering stress.

When the component carrier is a printed circuit board, it may be possible that a length of the micro- and/or nanostructures is in a range from 40 µm to 50 µm, whereas a diameter of the micro- and/or nanostructures may be in a range from 400 nm to 1 µm. When the component carrier is an integrated circuit substrate, it may be possible that a length of the micro- and/or nanostructures is in a range from 5 µm to 15 µm, whereas a diameter of the micro- and/or nanostructures may be in a range from 50 nm to 200 nm.

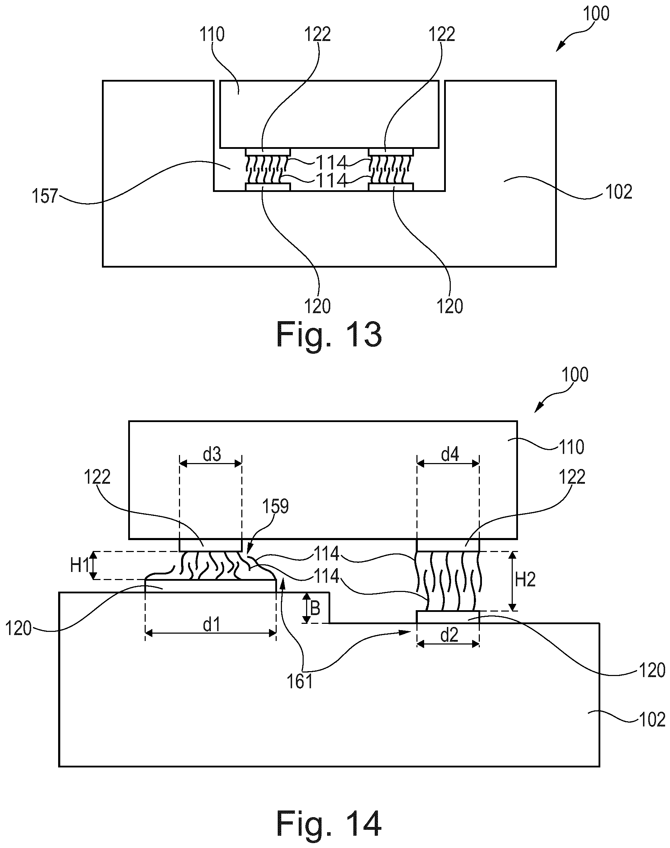

In an embodiment, the component carrier and/or the electronic component comprises pads of different sizes being connected by the connection structure comprising the micro- and/or nanostructures. Due to the flexible, elastic and/or bendable characteristic of the micro- and/or nanostructures, they may adapt themselves easily to pads of different sizes (see the left-hand side of Figure 14). A self-adaptive force connecting micro- and/or nanostructures to pads of different sizes may be an attractive magnetic force created by magnetic micro- and/or nanostructures. When entangling or engaging with each other, micro- and/or nanostructures extending from both pads to be connected may cooperate for balancing out different pad sizes. Also elastically deformable micro- and/or nanostructures bridging the entire spatial range between carrier pad and component pad may be capable of self-adjusting to different pad sizes.

In an embodiment, the component carrier and/or the electronic component comprises pads at different vertical levels connected by the connection structure comprising the micro- and/or nanostructures. Due to the flexible, elastic and/or bendable characteristic of the micro- and/or nanostructures, they may adapt themselves easily to different vertical pad-to-pad distances (compare the left-hand side with the right-hand side of Figure 14). When entangling with each other, micro- and/or nanostructures extending from both pads to be connected may cooperate for balancing out different vertical spacing. Also elastically deformable micro- and/or nanostructures bridging the entire spatial range between carrier pad and component pad may be capable of self-adjusting to different spacings.

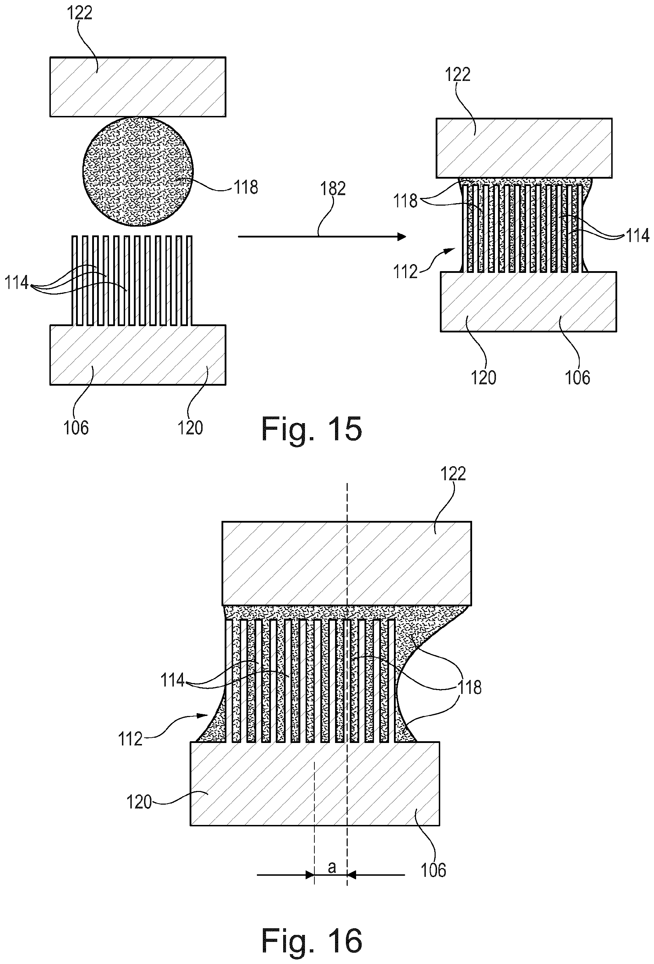

In an embodiment, centers of the at least one carrier pad and of the respective at least one component pad connected one to each other by the connection structure are misaligned one to each other in a lateral direction by a misalignment dimension in a range from 0.2 µm to 30 µm, in particular in a range from 0.3 µm to 25 µm (see Figure 16). An advantage of having high density distributed nanostructures is that, due to the capillary force, the solder will be constricted in the area where the nanowires are deposited. This may reduce the risk of shorts between adjacent pads due to the solder proximity. For this purpose, the at least one carrier pad and the respective at least one component pad may be aligned parallel with respect to the main surface (or direction), but transversally shifted. Micro- and/or nanostructures and/or a solder structure may be laterally placed between the at least one carrier pad and the respective at least one component pad. Due to the flexible, elastic and/or bendable characteristic of the micro- and/or nanostructures and/or due to capillary forces, the connection structure adapts itself to achieve reliable mechanical and/or electrical connection between the at least one carrier pad and the respective misaligned at least one component pad.

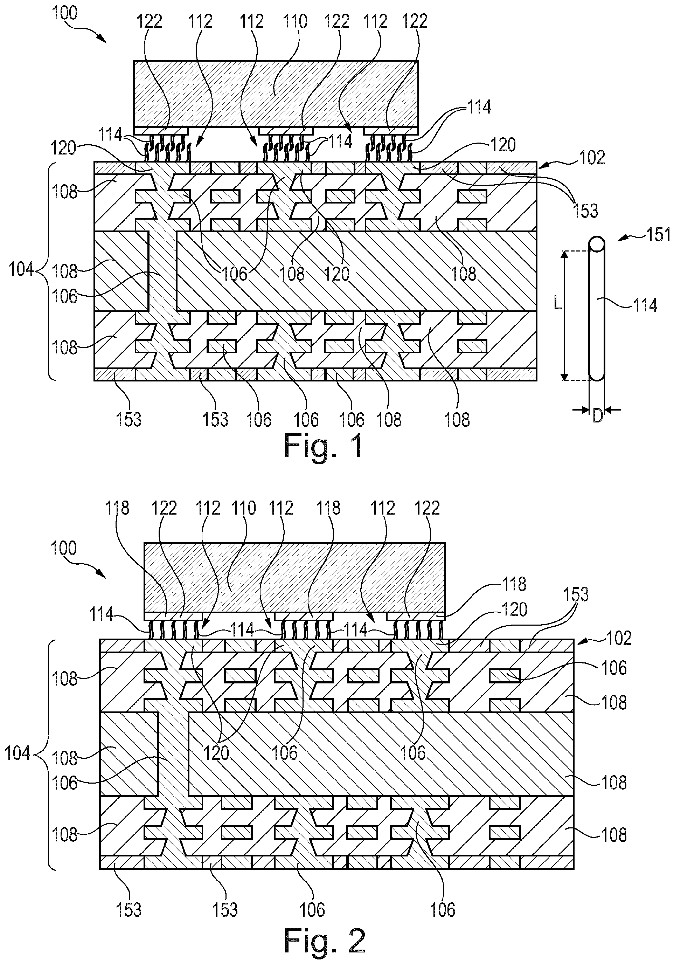

In an embodiment, the electronic component is surface mounted on the component carrier (see for example Figure 1). Thus, micro- and/or nanostructures may be used for establishing an electromechanical carrier-component connection in SMD (surface mounted device) technology.

Additionally or alternatively, an electronic component may be embedded in the component carrier (see Figure 13). Advantageously, it may also be possible to create an electromechanical connection between a component carrier and an electronic component when the latter is embedded in a cavity of the former. In such a scenario, a proper spatial alignment between pads of the component carrier and of the electronic component may be a challenge in conventional approaches, since the electronic component is to be placed in a cavity. However, it has been found that alignment issues in terms of embedding components in a component carrier may be relaxed by micro- and/or nanostructures extending from at least one, and preferably from both, of the opposing pads in view of the flexibility, deformability and/or elasticity of the micro- and/or nanostructures which may balance out some misalignment.

In an embodiment, the connection structure is formed only by the micro- and/or nanostructures. In particular, the connection structure may be solderless. Thus, no further constituents than micro- and/or nanostructures are used in such an embodiment for establishing an electromechanical connection between electronic component and component carrier. In such a scenario, it may be advantageous that micro- and/or nanostructures are provided on both the component pad(s) and the carrier pad(s) which may entangle with each other.

In an embodiment, the micro- and/or nanostructures extend over an entire spatial range between the at least one carrier pad and the at least one component pad. For instance, one end of a respective micro- and/or nanostructure may be connected to the carrier pad while the opposing other end thereof may be connected to the component pad. For example, the micro- and/or nanostructures may extend from the at least one carrier pad up to the at least one component pad, or vice versa. Hence, a respective micro- and/or nanostructure may bridge the entire spacing between the pads to be connected.

In an embodiment, the micro- and/or nanostructures are surrounded by a protection structure for protecting the micro- and/or nanostructures, in particular from air. For example, this can be accomplished by an appropriate functional coating of the micro- and/or nanostructures. By shielding the micro- and/or nanostructures with respect to air (or another medium in a surrounding, for instance humidity), undesired oxidation or corrosion may be prevented.

In an embodiment, micro- and/or nanostructures (in particular nanowires) grown on one carrier pad (for example of an IC substrate) may be split to be connected to at least two component pads, or vice versa. For example, carrier pads (for instance those which deliver power) can be split to two or more component pads by redirecting or bifurcating the micro- and/or nanostructures (such as nanowires).

In an embodiment, one connection between carrier pad and component pad may be made by a metal (for example copper) pillar (for instance for alignment of the component), and all the rest of the connections between carrier and component may be made by micro- and/or nanostructures (for example by nanowires). Furthermore, it may generally be also possible to form micro- and/or nanostructures on at least one pillar (for example metal pillar, preferably copper pillar) of the package (in particular of the component carrier and/or the component thereof).

In an embodiment, the package comprises a mounting base, in particular a printed circuit board (PCB), on which the component carrier is mounted. Such a mounting base may connect the component carrier and its surface mounted component(s) mechanically and electrically with an electronic periphery.

In an embodiment, the package comprises a carrier (in particular an IC substrate) on which a further carrier (such as a redistribution structure or coreless IC substrate or a plurality of those) is interconnected with micro- and/or nanostructures (such as nanowires). More specifically, a redistribution layer (RDL) may be formed on a substrate using micro- and/or nanostructures. Such an embodiment can be seen as a carrier composed of different layers of sub-carriers being interconnected via micro- and/or nanostructures. The sub-carriers may have different areas. In particular, a sub-carrier on the top may occupy a smaller area of a sub-carrier on the bottom.

In an embodiment, the component may be a silicon interposer, or in general, an interposer structure, for example a carrier with finer line structures than an IC substrate on which the component is mounted.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded therein. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a package according to an exemplary embodiment of the invention.
Figure 2 illustrates a cross-sectional view of a package according to another exemplary embodiment of the invention.
Figure 3 illustrates a cross-sectional view of a package according to still another exemplary embodiment of the invention.
Figure 4 illustrates a cross-sectional view of part of a pads-connection structure-arrangement of a package according to another exemplary embodiment of the invention.
Figure 5 illustrates a cross-sectional view of a complete connection structure comprising the part shown in Figure 4.
Figure 6 illustrates a cross-sectional view of a connection structure of a package according to an exemplary embodiment of the invention.
Figure 7 illustrates a cross-sectional view of a connection structure of a package according to still another exemplary embodiment of the invention.
Figure 8 illustrates a cross-sectional view of part of a pads-connection structure-arrangement of a package according to another exemplary embodiment of the invention.
Figure 9 illustrates a cross-sectional view of a complete connection structure comprising the part shown in Figure 8.
Figure 10 illustrates a cross-sectional view of a preform of a connection structure of a package according to still another exemplary embodiment of the invention.
Figure 11 illustrates a cross-sectional view of a preform of a connection structure of a package according to still another exemplary embodiment of the invention.
Figure 12 illustrates a cross-sectional view of part of a pads-connection structure-arrangement of a package according to still another exemplary embodiment of the invention.
Figure 13 illustrates a cross-sectional view of a package according to another exemplary embodiment of the invention.
Figure 14 illustrates a cross-sectional view of a package according to still another exemplary embodiment of the invention.
Figure 15 illustrates a cross-sectional view of part of a pads-connection structure-arrangement and a cross-sectional view of a corresponding complete connection structure of a package according to still another exemplary embodiment of the invention.
Figure 16 illustrates a cross-sectional view of a connection structure of a package according to an exemplary embodiment of the invention.
Figure 17 illustrates a cross-sectional view of a package according to still another exemplary embodiment of the invention.
Figure 18 illustrates a cross-sectional view of a package according to yet another exemplary embodiment of the invention.
Figure 19 to Figure 22 illustrate cross-sectional views of micro- and/or nanostructures on pads of packages according to other exemplary embodiments of the invention.
Figure 23 to Figure 25 show cross-sectional images of micro- and/or nanostructures on pads according to exemplary embodiments of the invention.
Figure 26 to Figure 29 illustrate cross-sectional views of structures obtained during carrying out a method of manufacturing a package according to an exemplary embodiment of the invention including growing micro- and/or nanostructures on a pad.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

In conventional packages, a CTE (coefficient of thermal expansion) mismatch in a horizontal mounting plane between material of a surface mounted electronic component (in particular a semiconductor chip comprising silicon) and a component carrier (in particular an IC substrate) may be a root cause for reliability issues of the package. Therefore, an interposer or the like needs to be mounted as intermediate body to mount electronic components on a component carrier. This may lead to a complex design and to a large space consumption of the package.

According to an exemplary embodiment of the invention, a package is composed of a laminate-type component carrier (such as a PCB or an IC substrate) and at least one surface mounted and/or embedded electronic component (like a semiconductor chip). An electromechanical connection between pads of the component carrier and of the electronic component may be accomplished by micro- and/or nanostructures in between. Advantageously, the micro- and/or nanostructures may be made of the same material as one or both of the connected pads. Realizing the electromechanical connection between pads of the component carrier and of the electronic component by micro- and/or nanostructures allows a simple manufacture while providing the connection with elasticity for balancing mechanical and/or thermal stress which may occur between component carrier and electronic component. At the same time, the connection may be electrically and mechanically reliable when using micro- and/or nanostructures. Advantageously, forming the micro- and/or nanostructures and at least one, preferably both, of the connected pads of the same material may avoid material bridges in between. This may result in a small contact or transition resistance between pad(s) and micro- and/or nanostructures which may lead to low electric power losses and/or low electric signal losses by the connection structure. Furthermore, the same material of micro- and/or nanostructures and a connected pad, by avoiding material bridges, may also enhance the mechanical integrity of the package and may prevent a CTE mismatch between connection structure and pad(s). Thus, a package with high mechanical and thermal reliability may be obtained. It may also be possible to grow the micro- and/or nanostructures directly on one or both of the component pad and the carrier pad. To put it shortly, micro- and/or nanostructures made of the same material as one or preferably both pads to be connected with each other by the connection structure may provide a stable and stress-resistant connection between a component carrier and an electronic component without the risk of cracks (which may occur conventionally as a consequence of a CTE mismatch).

In particular, micro- and/or nanostructures of a connection structure of a package (for instance a chip package) may form an interconnection that can take up a horizontal movement between component carrier and electronic component and compensate vertical height tolerances of component carrier and/or electronic component to improve the reliability of the package. Moreover, such a manufacturing architecture may provide an interconnection between component carrier and electronic component which may take up a lateral movement to at least partially compensate CTE mismatch in a horizontal plane.

The described package design according to an exemplary embodiment of the invention allows mounting of large electronic components (such as large silicon chips or interposers). A corresponding manufacturing architecture may be less stringent concerning height tolerances as conventional approaches. Furthermore, a higher connection reliability may be achieved than with a conventional package design. In particular when embodying the micro- and/or nanostructures as nanowires, very fine pitches can be achieved by the connection structure.

Advantageously, copper-grown wires may be used as micro- and/or nanostructures to improve reliability of the package. Copper-grown wires may have the advantage of a particularly high ductility and a low Young module. Moreover, an excellent levelling in vertical direction may be achieved. Furthermore, the package may be manufactured with an easy assembly process. Advantageously, a nanowire-reinforced solder joint may be formed in an embodiment to further improve thermal dissipation and reliability of the package.

Alternatively, carbon nanotubes may be used as the micro- and/or nanostructures.

An exemplary application of an exemplary embodiment of the invention is a high-performance computing (HPC) package. Furthermore, a package manufactured according to an exemplary embodiment of the invention may be capable of providing an ultra-high density interconnection.

Preferably, the micro- and/or nanostructures may form a spring-like connection between component carrier and electronic component. The micro- and/or nanostructures, which may be embodied as nanowires, may form both an electrically conductive and mechanically reliable connection between component carrier and electronic component while supporting fine pitch and reduced dimensions of the package. Furthermore, an array of micro- and/or nanostructures as connection structure may ensure an elastic electromechanical connection which is reliable even when individual ones of the micro- and/or nanostructures fail. Advantageously, a direct connection of micro- and/or nanostructures with other micro- and/or nanostructures may be permanent. While conventionally a pronounced flatness of component carrier and electronic component is of importance, micro- and/or nanostructures - upon pressing - can compensate different height levels. By such a levelling effect of micro- and/or nanostructures, it may be ensured even in the presence of warpage that all pads of electronic component and component carrier are reliably connected. Hence, a package design using micro- and/or nanostructures may be warpage tolerant. This may be of utmost advantage when using pads of different sizes (for instance larger pads for high-power, and smaller pads for transporting signals).

Exemplary embodiments of the invention may provide a package having an increased connection reliability between component carrier and electronic component. This may be achieved by using micro- and/or nanostructures made of a pad material for connecting said pad with another pad (which may be preferably also made of the same material). For instance, filament-type micro- and/or nanostructures may be used which may be configured for entangling or engaging with each other. It is also possible to configure the micro- and/or nanostructures, for instance when extending from both pads to be connected, in a hook and loop fashion.

**Figure 1** illustrates a cross-sectional view of a package 100 according to an exemplary embodiment of the invention.

The illustrated package 100 comprises a component carrier 102 (such as an integrated circuit substrate) and comprises an electronic component 110 mounted by a connection structure 112 on the component carrier 102. Alternatively, a number of electronic components 110 being surface mounted on the component carrier 102 may be at least two. Additionally or alternatively to the surface mounted component 110, it is also possible to embed one or more electronic components 110 in the component carrier 102 by establishing a connection as described herein for the connection between component carrier 102 and surface mounted electronic component 110.

For example, the component carrier 102 may comprise or consist of a laminated layer stack 104 comprising a plurality of electrically conductive layer structures 106 and of electrically insulating layer structures 108. The electrically conductive layer structures 106 may comprise patterned copper layers which may form horizontal pads and/or a horizontal wiring structure. Additionally or alternatively, the electrically conductive layer structures 106 may comprise vertical through connections such as copper pillars and/or copper filled laser vias. Moreover, the stack 104 of the component carrier 102 may comprise one or more electrically insulating layer structures 108 (such as prepreg or resin sheets). Also surface finish 153 (like ENIG or ENEPIG, a solder resist, etc.) may be optionally applied on the top side and/or on the bottom side of the stack 104. The lowermost electrically insulating layer structure 108 in Figure 1 is a surface finish 153 embodied as solder resist. The solder resist may support correct soldering of component carrier 102 on a mounting base below (not shown, for example a printed circuit board).

The electronic component 110 is here configured as bare die (i.e. nonencapsulated semiconductor chip) and is surface mounted on a top main surface of the component carrier 102. The electronic component 110 may be configured as semiconductor chip, for instance active semiconductor chip. Examples of the IC-type electronic component 110 are processors, memories, sensors, logic chips, microelectromechanical systems (MEMS), etc. The electronic component 110 may comprise an integrated circuit with at least one monolithically integrated circuit element, such as a transistor or a diode, in an active region. The electronic component 110 can also be a stacked IC, a module, a chiplet or a system-on-chip (SoC).

Still referring to Figure 1, the component carrier 102 comprises in its upper portion a plurality of exposed carrier pads 120. For instance, each of the carrier pads 120 is made of copper. Correspondingly, the illustrated electronic component 110 has exposed component pads 122. For instance, each of the component pads 122 is made of copper. Advantageously, the material of the carrier pads 120 and of the component pads 122 may be the same which may promote a firm connection by a connection structure 112 - which may also be made of the same material (copper in this example). The same material of pads 120, 122 and connection structure 112 may ensure a good reliability of package 100.

The connection structure 112 is configured for electromechanically connecting the carrier pads 120 with the component pads 122 by corresponding arrays of micro- and/or nanostructures 114. More specifically, each carrier pad 120 is connected with one assigned component pad 122 by one assigned set of entangling micro- and/or nanostructures 114. A respective array of micro- and/or nanostructures 114 extends from each of carrier pads 120 upwardly towards an assigned one of the component pads 122. Correspondingly, a respective further array of micro- and/or nanostructures 114 extends from each of component pads 122 downwardly towards an assigned one of the carrier pads 120. By pressing the component carrier 102 and the electronic component 110 together with carrier pads 120 and component pads 122 in mutual alignment, corresponding arrays of micro- and/or nanostructures 114 may entangle with each other for forming a reliable and permanent connection between component carrier 102 and electronic component 110. This connection may be so tight that it cannot be separated without destroying package 100. Alternatively, the arrays of micro- and/or nanostructures 114 may be designed so that they allow a reversible assembly and disassembly of component carrier 102 and electronic component 110.

Advantageously, all micro- and/or nanostructures 114 may be made of the same material as the carrier pads 120 and the component pads 122, i.e. copper in the described embodiment. The same materials may be identical materials. However, the same materials may also be materials differing only concerning technically unavoidable impurities or foreign particles, different material properties in terms of manufacturing tolerances, or different additives or minor constituents with an overall weight percentage of only a few weight percent and preferably less than 1 weight percent. For instance, the micro- and/or nanostructures 114 may be made of copper nanowires. When manufacturing part or all of the pads 120, 122 and part or all of the micro- and/or nanostructures 114 of the same material, direct formation (for instance direct growth) of the micro- and/or nanostructures 114 on the respective pads 120, 122 may be simplified. Furthermore, this may avoid or at least reduce material bridges between different materials in the arrangement 120-114-122. This may lead, in turn, to a reduced electrical and/or thermal contact resistance, and to a reduced or even eliminated CTE mismatch between connection structure 112 and pads 120, 122.

Advantageously, the micro- and/or nanostructures 114 comprise or consist of copper. Using copper both for the micro- and/or nanostructures 114 and for the electrically conductive layer structures 106 of the component carrier 102 ensures a perfect compatibility of the connection structure 112 with PCB technology and IC substrate technology where copper is the preferred choice.

Now referring to a detail 151, in which one micro- and/or nanostructure 114 is shown in a straight configuration for the purpose of illustration, a ratio between a length L and a diameter D may be for example 10 or more. For instance, the diameter D of the illustrated micro- and/or nanostructure 114 may be in a range from 10 nm to 5 µm. The length L of the shown micro- and/or nanostructure 114 may be for example in a range from 300 nm to 50 µm. The exact dimensions or a dimension distribution of the micro- and/or nanostructures 114 may be selected depending on the requirements of a specific application (for example larger for a PCB-type component carrier 102 and smaller for an IC substrate-type component carrier 102). The dimensions or a dimension distribution of the micro- and/or nanostructures 114 may be adjusted by correspondingly adjusting the manufacturing parameters of a plating or deposition process for manufacturing the micro- and/or nanostructures 114. Although the micro- and/or nanostructure 114 according to detail 151 is shown in a straight configuration, micro- and/or nanostructures 114 may in practice - due to their high aspect ratio - also occur for instance in a bent, curved, coiled, looped or spiral configuration, or a combination of the mentioned and/or other configurations.

According to Figure 1, a first part of the micro- and/or nanostructures 114 extends from the carrier pads 120 of the component carrier 102 towards the component pads 122 of the electronic component 110 and has free ends. Correspondingly, a second part of the micro- and/or nanostructures 114 extends from the component pads 122 of the electronic component 110 towards the carrier pads 120 of the component carrier 102 and has free ends. Consequently, the first part and the second part of the micro- and/or nanostructures 114 mesh to form an interconnected connection network. The different arrays of micro- and/or nanostructures 114 may form a respective two-dimensional forest of micro- and/or nanostructures 114, each forest extending from a respective one of the carrier pads 120 of the component carrier 102 or from the component pads 122 of the electronic component 110. Such two-dimensional forests of micro- and/or nanostructures 114 protruding from opposing and aligned pads 120, 122 may engage with each other by merely pressing component carrier 102 and electronic component 110 together forming a connection, in particular a permanent connection. Consequently, the micro- and/or nanostructures 114 on the functionally interacting pads 120, 122 may provide a permanent non-separable connection between the component carrier 102 and the electronic component 110. Preferably, the micro- and/or nanostructures 114 of a respective forest or array are mutually spaced with respect to each other so that there are gaps in between adjacent micro- and/or nanostructures 114. This may allow other micro- and/or nanostructures 114 from another forest or array to engage into the gaps for forming a reliable connection by mutually entangling micro- and/or nanostructures 114. According to Figure 1, the connection structure 112 is formed exclusively by the micro- and/or nanostructures 114, which allows for a single construction.

Advantageously, the micro- and/or nanostructures 114 may be configured to act as a spring to impart elastic properties to the connection structure 112. Preferably, the micro- and/or nanostructures 114 may act as a spring in accordance with the characteristics of Hooke's law. Such a spring characteristics of the micro- and/or nanostructures 114 may be adjusted in particular by an appropriate material selection (for example copper) and an appropriate selection of the aspect ratio (preferably in the range from 10 to 40). Also the density of the micro- and/or nanostructures 114, i.e. a number of micro- and/or nanostructures 114 per area of a respective pad 120, 122, may have an impact on the spring function of the micro- and/or nanostructures 114. Preferably, the micro- and/or nanostructures 114 acting as spring are configured to generate a restoring force in the event of an elongation within a connection plane between the component carrier 102 and the electronic component 110. In the presently described embodiment, the connection plane is a horizontal plane perpendicular to the paper plane of Figure 1. For instance in the event of shear forces, a mutual shift between the component carrier 102 and electronic component 110 may occur in said connection plane. The elastic spring function of the micro- and/or nanostructures 114 may generate a back driving force tending to drive back component carrier 102 and electronic component 110 in their mutual target position. In addition, said spring function may avoid cracks in the connection structure 112 due to a shear stress buffering effect in view of the described elasticity. Furthermore, the micro- and/or nanostructures 114 acting as spring may be configured to generate a restoring force in the event of an elongation (such as an expansion or a compression) along a connection direction between the component carrier 102 and the electronic component 110. In the presently described embodiment, the connection direction is a vertical direction in the paper plane of Figure 1. For instance in the event of tensile stress or compressive stress, a mutual shift between the component carrier 102 and the electronic component 110 may occur along said connection direction. The elastic spring function of the micro- and/or nanostructures 114 may generate a back driving force tending to bring back component carrier 102 and electronic component 110 in their mutual vertical target distance. In addition, said spring function may avoid cracks in the connection structure 112 due to the tensile and compressive stress buffering effect in view of the described elasticity. To put it shortly, spring connections are formed by the micro- and/or nanostructures 114 on both sides of the connection structure 112, i.e. facing the component carrier 102 and facing the electronic component 110.

**Figure 2** illustrates a cross-sectional view of a package 100 according to another exemplary embodiment of the invention.

The embodiment of Figure 2 differs from the embodiment of Figure 1 in particular in that, according to Figure 2, the connection structure 112 comprises a solder structure 118 (which may be formed by a corresponding material configuration of said component pads 122 or as a coating on said component pads 122). Said solder structure 118 is connected with free end portions of micro- and/or nanostructures 114 extending from the carrier pads 120. For example, the solder structure 118 may comprise or consist of tin or a tin alloy. The micro- and/or nanostructures 114 may be copper nanowires and the carrier pads 120 may be made of copper as well. As shown in Figure 2, a major portion of the micro- and/or nanostructures 114 is located outside of the solder structure 118, so that the elastic spring function of the micro- and/or nanostructures 114 may be effective. More specifically, the micro- and/or nanostructures 114 extend from the carrier pads 120 up to the solder-type component pads 122, i.e. bridge the entire distance between the carrier pads 120 and the component pads 122. It may be of utmost advantage that micro- and/or nanostructures 114 have a length capable of bridging the entire distance between the carrier pads 120 and the component pads 122. This may make it possible to create an integrally formed connection structure 112 with springy characteristics. A corresponding package 100 may have a very high reliability and may be manufactured in a simple way.

To put it shortly, the embodiment of Figure 2 corresponds to spring connections on an IC substrate and solder on the semiconductor chip.

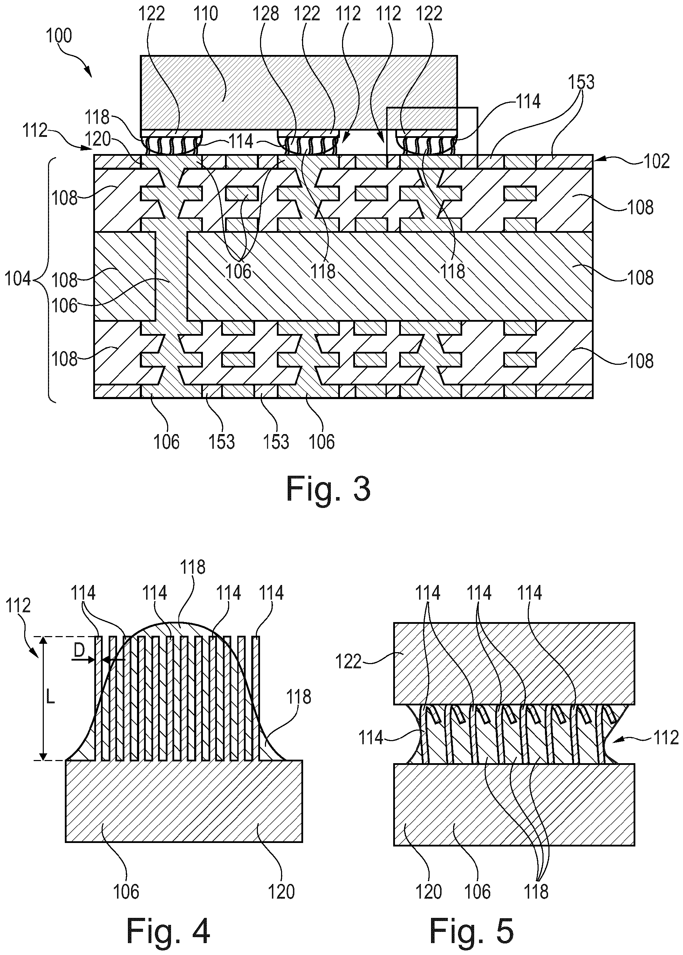

**Figure 3** illustrates a cross-sectional view of a package 100 according to still another exemplary embodiment of the invention.

The embodiment of Figure 3 differs from the embodiment of Figure 2 in particular in that, according to Figure 3, the micro- and/or nanostructures 114 are embedded almost completely or even entirely in the solder structure 118. In Figure 3, the solder structure 118 is embodied as a solder bump on the component pads 122. A two-dimensional array of micro- and/or nanostructures 114 extends from each carrier pad 120 towards or even up to the assigned component pad 122. Moreover, the micro- and/or nanostructures 114 are embedded in the solder structure 118 which extends over the entire gap between the respective carrier pad 120 and the respective component pad 122.

To put it shortly, the Figure 3 embodiment may form spring connections on the IC substrate and corresponding solder balls for encapsulation.

**Figure 4** illustrates a cross-sectional view of part of a pads-connection structure-arrangement of a package 100 according to another exemplary embodiment of the invention. **Figure 5** illustrates a cross-sectional view of a complete connection structure 112 comprising the part shown in Figure 5.

Descriptively speaking, Figure 4 illustrates a carrier pad 120 with micro- and/or nanostructures 114 extending therefrom and being made of the same material as the carrier pad 120, preferably copper. A solder structure 118 covers the carrier pad 120 and part of the micro- and/or nanostructures 114. The interconnection according to Figure 5 is obtained after component mounting and soldering, wherein at the end both the solder structure 118 and the micro- and/or nanostructures 114 extend over the whole gap between the carrier pad 120 and the component pad 122. This ensures both a reliable mechanical connection and a low-ohmic electric coupling of the carrier pad 120 with the component pad 122.

In an embodiment, it may be possible that a plurality of the micro- and/or nanostructures 114 may reverse its extending direction. As it is shown in Figure 5, the micro- and/or nanostructures 114 may extend from bottom to top. However, for instance due to a pressure force, they may be bent so that the extremities are pointing from top to bottom.

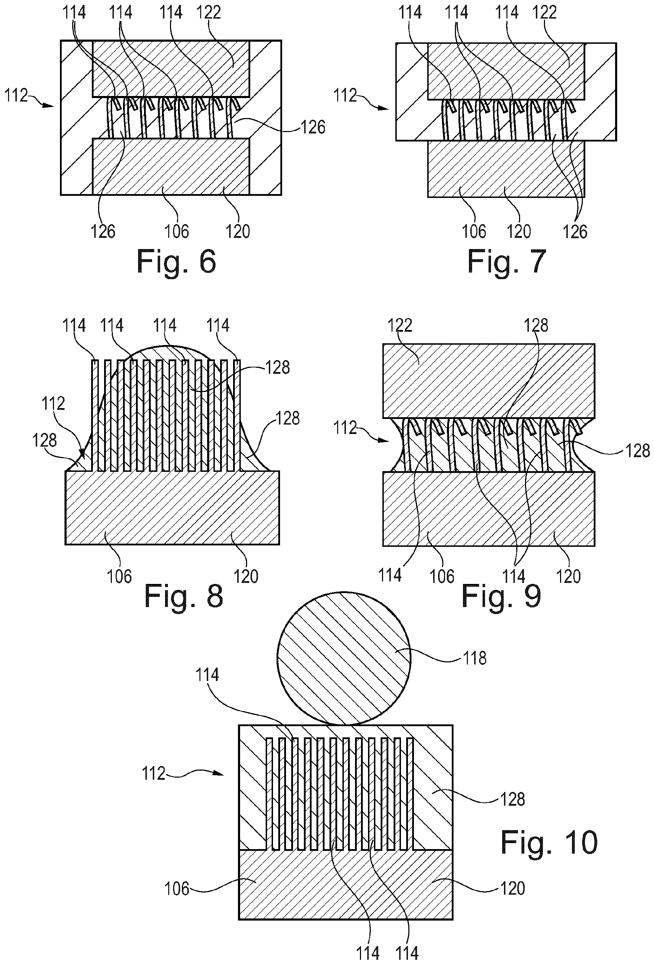

**Figure 6** and **Figure 7** illustrate cross-sectional views of connection structures 112 of packages 100 according to still other exemplary embodiments of the invention. In each of these embodiments, an electrically insulating underfill 126 is provided to fill a gap between the shown carrier pad 120 of the component carrier 102 and the illustrated component pad 122 of the electronic component 110. Hence, these embodiments may fill a vertical gap between component carrier 102 and electronic component 110 without solder. As shown, the dielectric underfill 126 covers the entire micro- and/or nanostructures 114. In Figure 6, the dielectric underfill 126 fills also a volume below the upper horizontal main surface of the carrier pad 120 and therefore also covers side walls thereof. In Figure 7, the dielectric underfill 126 fills only a volume above the upper horizontal main surface of the carrier pad 120 and therefore keeps side walls thereof exposed. This may have the advantage of protecting at least part of the surface of the micro- and/or nanostructures 114 from oxidation and/or corrosion.

**Figure 8** illustrates a cross-sectional view of part of a pads-connection structure-arrangement of a package 100 according to another exemplary embodiment of the invention. **Figure 9** illustrates a cross-sectional view of a complete connection structure 112 comprising the part shown in Figure 8.

The embodiment of Figure 8 and Figure 9 differs from the embodiment of Figure 4 and Figure 5 in particular in that, according to Figure 8 and Figure 9, the micro- and/or nanostructures 114 are surrounded by a protection structure 128 for protecting the micro- and/or nanostructures 114 from air and being embodied as non-conductive paste or liquid glue. Hence, the copper nanowire structures may be protected against oxidation and corrosion by surrounding oxygen or humidity.

**Figure 10** illustrates a cross-sectional view of a preform of a connection structure 112 of a package 100 according to still another exemplary embodiment of the invention.

Figure 10 shows micro- and/or nanostructures 114 extending from a carrier pad 120 and being surrounded by a temporary protection structure 128 which is here embodied as flux for soldering. A microball, which may be made of a solder material such as tin or a tin alloy, is arranged as a solder structure 118 on top of the temporary protection structure 128. When subjecting the structure shown in Figure 10 to a temperature treatment (for example by exposing said structure to reflow soldering conditions), the flux will be dissipated and the solder structure 118 will be converted into the configuration of Figure 4.

Thus, Figure 10 shows a possibility as to how to apply solder within nanowires.

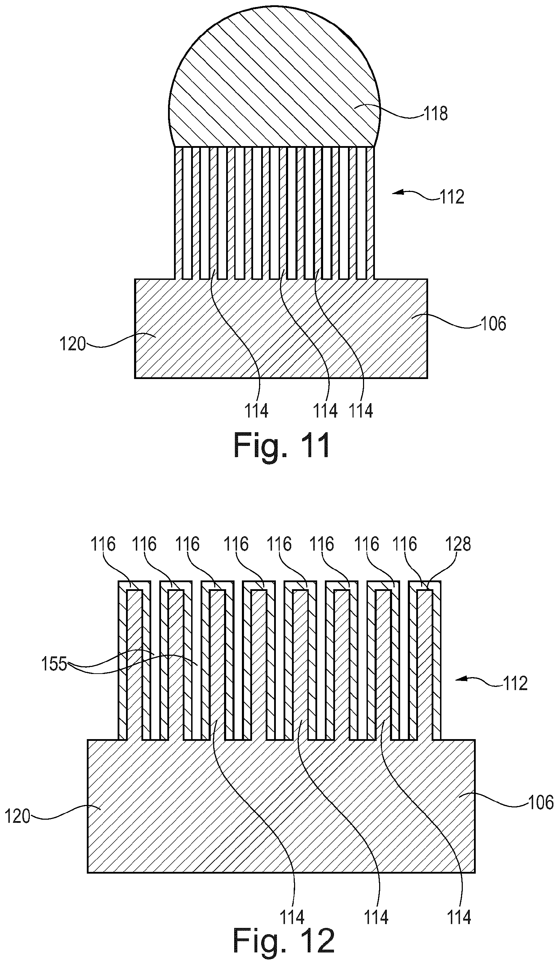

**Figure 11** illustrates a cross-sectional view of a preform of a connection structure 112 of a package 100 according to still another exemplary embodiment of the invention.

Figure 11 shows exposed micro- and/or nanostructures 114 extending from a carrier pad 120. On top of the micro- and/or nanostructures 114, a solder structure 118 is provided. Such a structure can be manufactured for example by dispensing, screen printing, aerosol jetting or other additive methods.

Although not shown in Figure 11, it may also be possible that by applying the solder structure 118, part of it may penetrate the micro- and/or nanostructures 114 (for instance a nanowire forest) even before thermal treatment.

When subjecting the structure shown in Figure 11 to a temperature treatment (for example by exposing said structure to reflow conditions), the solder structure 118 will become flowable and will flow in gaps between adjacent micro- and/or nanostructures 114 so as be converted into the configuration of Figure 4.

Hence, Figure 11 shows another possibility as to how to apply solder within nanowires.

**Figure 12** illustrates a cross-sectional view of part of a pads-connection structure-arrangement of a package 100 according to still another exemplary embodiment of the invention.

The embodiment of Figure 12 differs from the embodiment of Figure 4 in particular in that, according to Figure 12, the micro- and/or nanostructures 114 are coated by a functional coating 116 which is here made of a solder material (for example comprising or consisting of tin or a tin alloy). Consequently, empty gaps 155 may remain between different coated micro- and/or nanostructures 114. Such gaps 155 may be filled with cooperating other micro- and/or nanostructures 114 extending downwardly from a component pad 122 (not shown in Figure 12). In the shown embodiment, the functional coating 116 may enhance solderability of the micro- and/or nanostructures 114. The latter may be formed preferably from copper, for instance may be copper nanowires. For instance, the functional coating 116 may be formed by electroless deposition, by electroplating, by physical vapor deposition (PVD).

Additionally or alternatively to the described function, the functional coating 116 may also be configured for enhancing thermal conductivity, electric conductivity and/or may protect the micro- and/or nanostructures 114 against oxidation or corrosion. The material of the functional coating 118 may be adapted to the assigned function.

**Figure 13** illustrates a cross-sectional view of a package 100 according to another exemplary embodiment of the invention.

According to Figure 13, the electronic component 110 is embedded in a cavity 157 of the component carrier 102. As shown in Figure 13, an upper main surface of the embedded electronic component 110 may be exposed to an environment. Alternatively, it is also possible to embed the electronic component 110 completely in an interior of the component carrier 102 so that the embedded electronic component 110 is fully circumferentially surrounded by material of the component carrier 102 (not shown).

When embedding one or more electronic components 110 in a component carrier 102, the electromechanical connection between the component carrier 102 and the electronic component(s) 110 may be accomplished as described herein for any embodiment relating to a surface mounted electronic component 110, for instance as described referring to any of Figure 1 to Figure 12.

**Figure 14** illustrates a cross-sectional view of a package 100 according to another exemplary embodiment of the invention.

As shown in Figure 14, the component carrier 102 comprises carrier pads 120 of different sizes d1, d2, wherein in the shown example d1>d2. Furthermore, the electronic component 110 may comprise component pads 122 of different sizes d3, d4. Beyond this, sizes of a corresponding pair of a carrier pad 120 and a component pad 122 to be interconnected by a connection structure 112 may be different as well, in the shown embodiment d1>d3. As shown by reference sign 159, even in such a scenario, the flexible, bendable and elastic configuration of micro- and/or nanostructures 114 may nevertheless allow for establishing a reliable connection between such pads 120, 122 of different sizes. For example, a self-adaptive force connecting micro- and/or nanostructures 114 between pads 120, 122 of different sizes may be an attractive magnetic force created by magnetic micro- and/or nanostructures 114, and optionally also by pads 120 and/or 122 when made of a magnetic material.

Still referring to Figure 14, it may also be possible that the component carrier 102 comprises carrier pads 120 at different vertical levels, for instance with bottom main surfaces being mutually vertically spaced by a distance B. Although not shown, component pads 122 at different vertical levels may also be present at an electronic component 110. As shown by reference sign 161, even in such a scenario, the flexible, bendable and elastic configuration of micro- and/or nanostructures 114 may nevertheless allow for establishing a reliable connection involving carrier pads 120 at different vertical levels. The micro- and/or nanostructures 114 may be capable of bridging different vertical spacings H2>H1.

**Figure 15** illustrates a cross-sectional view of part of a pads-connection structure-arrangement and a cross-sectional view of a corresponding complete connection structure 112 of a package 100 according to still another exemplary embodiment of the invention. As shown in Figure 15, solder structure 118 is applied on the component pad 122 or bump and assembled on the carrier pad 120 or bump with micro- and/or nanostructures 114 (such as nanowires) thereon. Of course, an inverse configuration can also be implemented (i.e. solder structure 118 on carrier pad 120 and micro- and/or nanostructures 114 on the component pad 122). Transition 182 can be accomplished by assembly and reflow.

**Figure 16** illustrates a cross-sectional view of a connection structure 112 of a package 100 according to an exemplary embodiment of the invention. As shown by displaced vertical lines in Figure 16, centers of the carrier pad 120 and of the respective component pad 122 connected with each other by the connection structure 112 are misaligned with respect to each other in a lateral direction by a misalignment dimension "a". The latter may be in a range from 0.2 µm to 30 µm, for instance in a range from 0.3 µm to 25 µm. An advantage of having high density distributed nanostructures is that, due to the capillary force, the solder may be constricted in the area where the nanowires are deposited. This may reduce the risk of a short between adjacent pads due to the solder proximity.

**Figure 17** illustrates a cross-sectional view of a package 100 according to still another exemplary embodiment of the invention. In this embodiment, the stack 104 comprises an external layer structure 180 in form of the solder mask 153 covering lateral walls and also covering a portion of an upper exposed surface of the carrier pads 120. Advantageously, the external layer structure 180 may form a protection for the carrier pads 120, for example against oxidation. According to Figure 17, the bottom portion of the connection structure 112 is embedded by solder resist 153, whereas a top portion of the connection structure 112 is embedded in underfill 126. It should be mentioned that solder mask 153 is applied to protect the copper pads and tracks from the environment. However, a non-solder mask protection may be possible as well.

**Figure 18** illustrates a cross-sectional view of a package 100 according to yet another exemplary embodiment of the invention. In this embodiment, the stack 104 comprises an external layer structure 180 in form of underfill 126 covering lateral walls and also covering a portion of a horizontal exposed surfaces of the carrier pads 120 and of the component pads 122. Again, the external layer structure 180 may protect the carrier pads 120 and the component pads 122 against impact from the environment. According to Figure 18, the connection structure 112 is embedded entirely in underfill 126. Another embodiment uses underfilling under the die area and a solder mask on the surrounding.

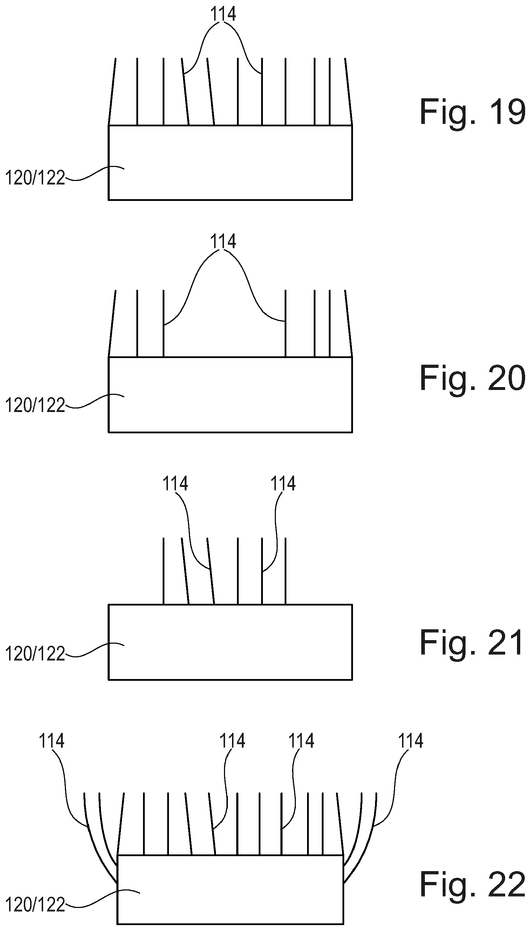

Figure 19 to Figure 22 illustrate cross-sectional views of micro-and/or nanostructures 114 on carrier pads 120 or component pads 122 of packages 100 according to other exemplary embodiments of the invention. As shown, the micro/nano structures 114 may grow on one entire area of the pads 120/122 (which may be the preferred option), or only dedicated parts of the area (such as a central part, or a periphery). However, the micro- and/or nano structures 114 may grow additionally on side walls of the respective pad 120/122.

Referring to **Figure 19****,** the micro-and/or nanostructures 114 are arranged on an entire main surface of the carrier pad 120/component pad 122.

Referring to **Figure 20****,** the micro-and/or nanostructures 114 are arranged only on a peripheral part of the main surface of the carrier pad 120/component pad 122, whereas a central part of the main surface of the carrier pad 120/component pad 122 is free of micro-and/or nanostructures 114.

Referring to **Figure 21****,** the micro-and/or nanostructures 114 are arranged only on a central part of the main surface of the carrier pad 120/component pad 122, whereas a peripheral part of the main surface of the carrier pad 120/component pad 122 is free of micro-and/or nanostructures 114.

Referring to **Figure 22****,** the micro-and/or nanostructures 114 are arranged on the main surface of the carrier pad 120/component pad 122, and additionally on at least part of a sidewall of the carrier pad 120/component pad 122.

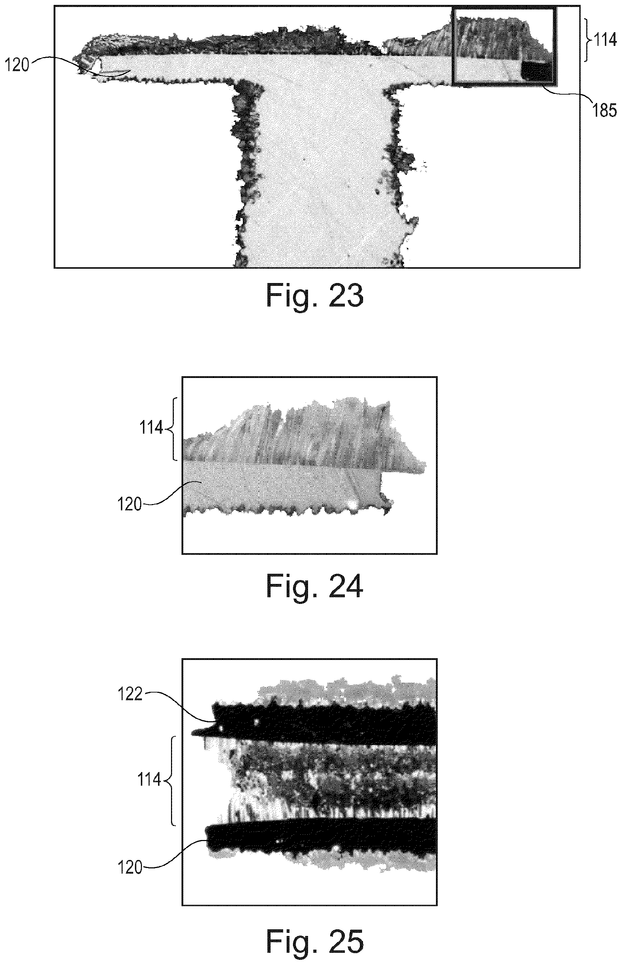

Figure 23 to Figure 25 show cross-sectional images of micro- and/or nanostructures 114 on pads 120, 122 according to exemplary embodiments of the invention.

Referring to **Figure 23****,** micro- and/or nanostructures 114 grown on a pad 120 are shown.

Referring to **Figure 24****,** a detail (indicated by a rectangle 185 in Figure 23) of the micro- and/or nanostructures 114 grown on the pad 120 of Figure 23 are shown.

Referring to **Figure 25****,** micro- and/or nanostructures 114 grown on both opposing pads 120, 122 are shown. The micro- and/or nanostructures 114 attached to the exposed surface of the carrier pad 120 extending in the direction toward the component pad 122 and the micro- and/or nanostructures 114 attached to the exposed surface of the component pad 122 extending in the direction toward the carrier pad 120 mesh to form an interconnected connection network in the portion between the component pad 122 and the carrier pad 120.

Still referring to Figure 23 to Figure 25, at the periphery part of the carrier pad 120 or component pad 122, the micro- and/or nanostructures 114 (here embodied as nanowires) are smaller with respect to the length (L) than in the central part, which creates an inclination in the cross-sectional view, as best seen in Figure 24.

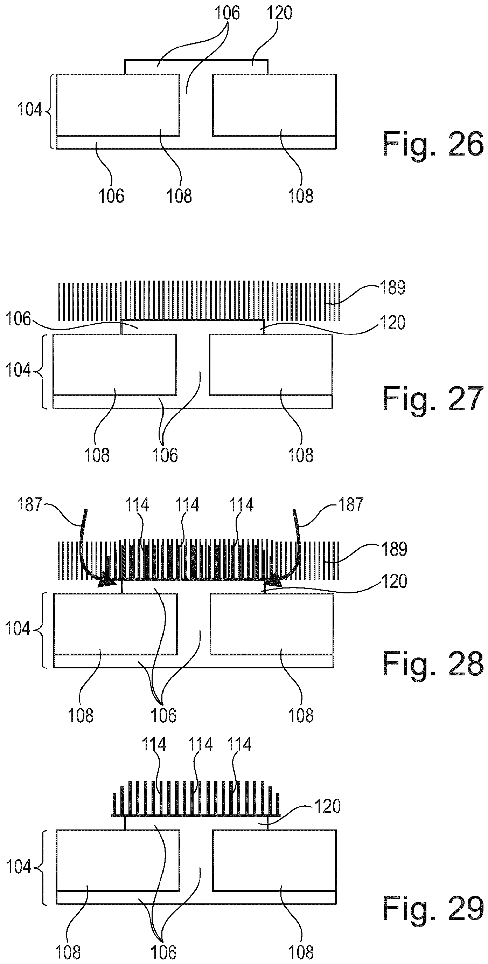

Figure 26 to Figure 29 illustrate cross-sectional views of structures obtained during carrying out a method of manufacturing a package 100 according to an exemplary embodiment of the invention including growing micro- and/or nanostructures 114 on a pad 120.

Referring to **Figure 26****,** an exposed carrier pad 120 on top of a stack 104 is shown. To put it shortly, a pad on a PCB is illustrated.

Referring to **Figure 27****,** a porous layer 189 is formed on top of the stack 104 including the carrier pad 120. The porous layer 189 is pressed on the exposed pad 120 during the deposition process.

Referring to **Figure 28****,** nanowire deposition is triggered by a chemistry flow, as indicated by reference sign 187.

Referring to **Figure 29****,** the porous layer 189 is removed.

As shown, when there is no photoresist masking the edges of pad 120, the chemistry flows through the porous layer 189 on the sides of the copper pad 120. This may increase slightly its diameter in a plate-like manner, and as soon as it reaches the bottom layer of the porosity layer, the nanowires start growing within it. The nanowires on the edges of such a pad 120 may be shorter as the volume of copper deposited is the same as in the middle, it just started from the side of the pad 120.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A package (100), which comprises:
a component carrier (102) having a stack (104) comprising at least one electrically conductive layer structure (106) and at least one electrically insulating layer structure (108), wherein the at least one electrically conductive layer structure (106) comprises at least one carrier pad (120);
an electronic component (110) assembled with the component carrier (102) and comprising at least one component pad (122); and
a connection structure (112) configured for electromechanically connecting the at least one carrier pad (120) with the at least one component pad (122) by micro- and/or nanostructures (114);
wherein the micro- and/or nanostructures (114) are made of the same material as the at least one carrier pad (120) and/or the at least one component pad (122).

2. The package (100) according to claim 1, wherein the micro- and/or nanostructures (114) comprise nanowires, in particular copper nanowires, and/or a micro- and/or nano-porous body, in particular nano-porous copper.

3. The package (100) according to claim 1 or 2, wherein the micro- and/or nanostructures (114) comprise or consist of a metal, preferably copper.

4. The package (100) according to any of claims 1 to 3, wherein the micro- and/or nanostructures (114) have a ratio between a length (L) and a diameter (D) of at least 10, in particular of at least 40.

5. The package (100) according to any of claims 1 to 4, wherein the micro- and/or nanostructures (114) are mutually spaced with respect to each other, in particular at and/or next to a common base from which the micro- and/or nanostructures (114) extend.

6. The package (100) according to any of claims 1 to 5, wherein the micro- and/or nanostructures (114) are configured to act as a spring, in particular to impart elastic properties to the connection structure (112).

7. The package (100) according to any of claims 1 to 6, wherein the micro- and/or nanostructures (114) are coated by a functional coating (116).

8. The package (100) according to any of claims 1 to 7, wherein a first part of the micro- and/or nanostructures (114) extends from the component carrier (102) towards the electronic component (110), and wherein a second part of the micro- and/or nanostructures (114) extends from the electronic component (110) towards the component carrier (102), so that the first part and the second part of the micro- and/or nanostructures (114) mesh to form an interconnected connection network.

9. The package (100) according to any of claims 1 to 8, wherein the connection structure (112) comprises a solder structure (118) being connected with the micro- and/or nanostructures (114), in particular with the micro- and/or nanostructures (114) extending only from one of the component carrier (102) and the electronic component (110).

10. The package (100) according to any of claims 1 to 9, wherein the component carrier (102) and/or the electronic component (110) comprises pads (120, 122) of different sizes (d1, d2, d3, d4) being connected by the connection structure (112) comprising the micro- and/or nanostructures (114).

11. The package (100) according to any of claims 1 to 10, wherein the component carrier (102) and/or the electronic component (110) comprises pads (120, 122) at different vertical levels connected by the connection structure (112) comprising the micro- and/or nanostructures (114).

12. The package (100) according to any of claims 1 to 11, wherein the micro- and/or nanostructures (114) are surrounded by a protection structure (128) for protecting the micro- and/or nanostructures (114), in particular from air.

13. The package (100) according to any of claims 1 or 12, wherein the stack (104) comprises an external layer structure (180) covering lateral walls, in particular also covering a portion of an upper exposed surface, of the at least one carrier pad (120).

14. The package (100) according to any of claims 1 to 13, wherein centers of the at least one carrier pad (120) and of the respective at least one component pad (122) connected one to each other by the connection structure (112) are misaligned one to each other in a lateral direction by a misalignment dimension (a) in a range from 0.2 µm to 30 µm, in particular in a range from 0.3 µm to 25 µm.

15. A method of manufacturing a package (100), wherein the method comprises:
providing a component carrier (102) having a stack (104) comprising at least one electrically conductive layer structure (106) and at least one electrically insulating layer structure (108), wherein the at least one electrically conductive layer structure (106) comprises at least one carrier pad (120);
assembling an electronic component (110), which comprises at least one component pad (122), with the component carrier (102); and
electromechanically connecting the at least one carrier pad (120) with the at least one component pad (122) by a connection structure (112) comprising micro- and/or nanostructures (114), wherein the micro- and/or nanostructures (114) are made of the same material as the at least one carrier pad (120) and/or the at least one component pad (122).
